# EUROPEAN PATENT SPECIFICATION

(11) **EP 3 319 135 B1**
(45) Date of publication and mention of the grant of the patent: **06.05.2020**
(21) Application number: 16817398.7
(22) Date of filing: 28.03.2016
(51) Int. Cl.: H01L 43/10, H01L 49/00

(54) **BATTERY AND CHARGING/DISCHARGING METHOD THEREFOR**
BATTERIE UND LADE-/ENTLADEVERFAHREN DAFÜR
BATTERIE ET SON PROCÉDÉ DE CHARGE/DÉCHARGE

(30) Priority: 02.07.2015 JP 2015133351
(43) Date of publication of application: 09.05.2018
(73) Proprietor: Kabushiki Kaisha Nihon Micronics, Musashino-shi, Tokyo 180-8508 (JP)
(72) Inventor: OGASAWARA, Juri, Tokyo 180-8508 (JP); HIWADA, Kiyoyasu, Tokyo 180-8508 (JP)
(74) Representative: Guérin, Jean-Philippe
(86) International application number: PCT/JP2016/001794
(87) International publication number: WO 2017/002284

(56) References cited:
- EP-A1- 2 838 148
- WO-A1-2013/146303
- JP-A- H1 140 449
- JP-A- 2005 093 768
- JP-A- 2009 027 868
- JP-A- 2014 154 223
- JP-A- 2015 115 130

## Description

### Technical Field

The present invention relates to a battery and a method of charging and discharging the same.

### Background Art

A battery that utilizes a photoexcitation structural change of a metal oxide caused by ultraviolet irradiation (the battery is hereinafter referred to as a quantum battery) has been developed by the applicant of the present application (Patent Literature 1 and 2). The quantum battery disclosed in Patent Literature 1 and 2 is expected to be a technique for achieving a battery having a capacity that far exceeds the capacity of a lithium ion battery. The secondary battery disclosed in Patent Literature 1, 2 and 3 has a structure in which a first electrode, an n-type metal oxide semiconductor layer, a charging layer, a p-type semiconductor layer, and a second electrode are laminated on a substrate.

### Citation List

### Patent Literature

[Patent Literature 1] International Patent Publication No. WO 2012/046325 [Patent Literature 2] International Patent Publication No. WO 2013/065093 [Patent Literature 3] Japanese Patent Application JP 2014-15223 A

### Summary of Invention

### Technical Problem

Such a quantum battery has a parallel plate type structure to achieve a thinned battery. Specifically, the charging layer is disposed between the first electrode and the second electrode, and the first electrode and the second electrode are formed over the entire surface of the charging layer. In order to control the charge and discharge characteristics, it is necessary to adjust the components and thicknesses of the oxide semiconductor layer and the charging layer. Accordingly, there is a problem that, if the components and thicknesses of the oxide semiconductor layer and the charging layer are determinate, it is difficult to adjust the charge and discharge characteristics.

The present invention has been made in view of the above-mentioned problem. According to the present invention, it is possible to provide a battery having desired characteristics.

### Solution to Problem

A battery according to an aspect of the present invention includes: a first electrode layer; a second electrode layer; and a charging layer disposed between the first electrode layer and the second electrode layer. The charging layer includes an n-type metal oxide semiconductor and an insulating material. On a surface of the charging layer, a region in which the second electrode layer is formed is sandwiched between regions in which the second electrode layer is not formed.

In the battery described above, in an arbitrary direction on the surface of the charging layer, the region in which the second electrode layer is formed and the region in which the second electrode layer is not formed may be alternately arranged.

A battery according to an aspect of the present invention includes: a first electrode layer; a second electrode layer; and a charging layer disposed between the first electrode layer and the second electrode layer. The charging layer includes an n-type metal oxide semiconductor and an insulating material. In an arbitrary direction on a surface of the charging layer, a region in which the second electrode layer is formed and a region in which the second electrode layer is not formed are alternately arranged.

A battery according to an aspect of the present invention includes: a first electrode layer; a second electrode layer; and a charging layer disposed between the first electrode layer and the second electrode layer. The charging layer includes an n-type metal oxide semiconductor and an insulating material. On a surface of the charging layer, at least a part of a region in which the second electrode layer is formed is disposed between regions in which the second electrode layer is not formed. On the surface of the charging layer, at least a part of a region in which the second electrode layer is not formed is disposed between regions in which the second electrode layer is formed.

In the battery described above, on the surface of the charging layer, the first electrode layer and the second electrode layer are divided into a plurality of patterns.

A battery according to an aspect of the present invention includes: a first electrode layer; a second electrode layer; and a charging layer including an n-type metal oxide semiconductor and an insulating material, a charge voltage generated between the first electrode layer and the second electrode layer being applied to the charging layer. On a surface of the charging layer, the first electrode layer and the second electrode layer is locally formed.

In the battery described above, in a planar view through the charging layer, an overlapping region in which a pattern of the first electrode layer and a pattern of the second electrode layer overlap each other and a non-overlapping region in which a pattern of the first electrode layer and a pattern of the second electrode layer do not overlap each other are alternately formed.

A battery according to an aspect of the present invention includes: a first electrode layer; a second electrode layer; and a charging layer including an n-type metal oxide semiconductor and an insulating material, a charge voltage generated between the first electrode layer and the second electrode layer being applied to the charging layer. The second electrode layer includes a plurality of electrode layer patterns formed separately from each other. During charging, the charge voltage is supplied to each of the plurality of electrode patterns, and during discharging, a load is connected to some of the plurality of electrode patterns.

In the battery described above, the charging layer may be charged with power generated by natural energy power generation.

In the battery described above, the charging layer may be charged with regenerated energy from a motor, and power charged in the charging layer may be used for a power source of the motor.

A method of charging and discharging a battery according to an aspect of the present invention is a method of charging and discharging a battery including: a first electrode layer; a second electrode layer; and a charging layer including an n-type metal oxide semiconductor and an insulating material, a charge voltage generated between the first electrode layer and the second electrode layer being applied to the charging layer, the second electrode layer including a plurality of patterns formed separately from each other, the method including: charging the battery by supplying the charge voltage to each of the plurality of patterns; and discharging the battery by connecting a load to some of the plurality of patterns.

### Advantageous Effects of Invention

According to the present invention, it is possible to provide a battery having desired characteristics, and a method of charging and discharging the same.

### Brief Description of Drawings

Fig. 1 is a perspective view showing a basic structure of a quantum battery;
Fig. 2 is a sectional view showing the basic structure of the quantum battery;
Fig. 3 is a plan view schematically showing a battery used in an experiment for confirming a phenomenon of electron leakage;
Fig. 4 is a diagram for explaining the phenomenon of electron leakage;
Fig. 5 is a diagram for explaining the phenomenon of electron leakage;
Fig. 6 is a diagram for explaining the phenomenon of electron leakage;
Fig. 7 is a diagram for explaining the phenomenon of electron leakage;
Fig. 8 is a perspective view schematically showing a structure of a quantum battery not forming part of the present invention;
Fig. 9 is a sectional view schematically showing the structure of the quantum battery not forming part of the present invention;
Fig. 10 is a schematic view showing a portion indicated by a dashed line in Fig. 9;
Fig. 11 is a graph showing relationships between discharge characteristics and a pattern width W and a distance L between patterns;
Fig. 12 is a diagram showing a responsiveness to a charge input;
Fig. 13 is a perspective view showing a structure of a quantum battery according to a first layout example;
Fig. 14 is a plan view showing the structure of the quantum battery according to the first layout example;
Fig. 15 is a sectional view showing the structure of the quantum battery according to the first layout example;
Fig. 16 is a perspective view showing a structure of a quantum battery according to a second layout example not forming part of the invention;
Fig. 17 is a plan view showing the structure of the quantum battery according to the second layout example not forming part of the invention;
Fig. 18 is a sectional view showing the structure of the quantum battery according to the second layout example not forming part of the invention;
Fig. 19 is a perspective view showing a structure of a quantum battery according to a third layout example not forming part of the invention;
Fig. 20 is a plan view showing the structure of the quantum battery according to the third layout example not forming part of the invention;
Fig. 21 is a sectional view showing the structure of the quantum battery according to the third layout example not forming part of the invention;
Fig. 22 is a diagram simply showing a regeneration system using a quantum battery;
Fig. 23 is a graph showing a charge curve in the regeneration system; and
Fig. 24 is a graph showing a discharge curve at start-up of a motor in the regeneration system.

### Description of Embodiments

Embodiments of the present invention will be described with reference to the accompanying drawings. Embodiments described below are examples of the present invention. The present invention is not limited to the following embodiments. Note that components denoted by the same reference numerals in the following description and the drawings indicate the same components.

### (A) Regarding a quantum battery

A technique of a quantum battery is applied to batteries according to embodiments described below. Accordingly, prior to the description of embodiments, the quantum battery will be briefly explained.

The quantum battery is a metal oxide semiconductor secondary battery utilizing a photoexcitation structural change of a metal oxide semiconductor. The quantum battery is a battery (secondary battery) based on the operation principle which traps the electrons by forming a new energy level in a band gap.

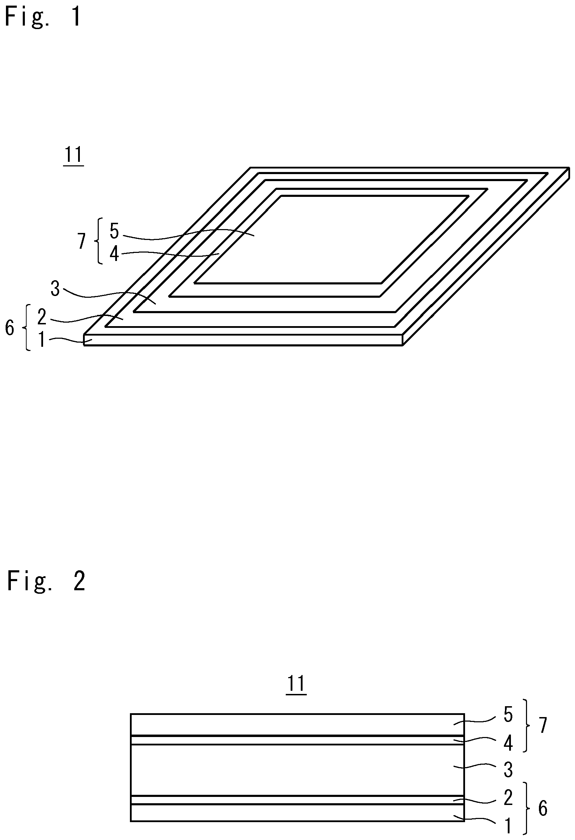

The quantum battery is an all-solid state physical secondary battery and functions as a battery by itself. An example of the structure of the quantum battery is shown in Figs. 1 and 2. Fig. 1 is a perspective view showing the structure of a quantum battery 11 having a parallel plate type structure, and Fig. 2 is a plan view thereof. Note that in Figs. 1 and 2, the illustration of terminal members, such as a positive terminal and a negative terminal, and mounting members, such as a covering member and a coating member, is omitted.

The quantum battery 11 includes a charging layer 3, a first electrode layer 6, and a second electrode layer 7. The charging layer 3 is disposed between the first electrode layer 6 and the second electrode layer 7. Accordingly, a charge voltage generated between the first electrode layer 6 and the second electrode layer 7 is applied to the charging layer 3. The charging layer 3 accumulates (traps) electrons by a charge operation, and emits the accumulated electrons by a discharge operation. The charging layer 3 is a layer that retains (stores) electrons in a state where the battery is not charged. The charging layer 3 is formed by applying a technique of photoexcitation structural change.

The term "photoexcitation structural change" is described in, for example, International Patent Publication No. WO2008/053561. The photoexcitation structural change is a phenomenon in which the distance between atoms of a material excited by irradiation of light varies. For example, an n-type metal oxide semiconductor, which is an amorphous metal oxide such as a tin oxide, has a property to cause a photoexcitation structural change. The phenomenon of photoexcitation structural change causes a new energy level to be formed in a band gap of an n-type metal oxide semiconductor. The quantum battery 11 is charged by trapping electrons at the energy levels, and is discharged by emitting the trapped electrons.

The charging layer is formed with a material including an n-type metal oxide semiconductor and an insulating material. Fine particles of an n-type metal oxide semiconductor covered with an insulating coating are filled in the charging layer 3. The n-type metal oxide semiconductor undergoes a photoexcitation structural change by ultraviolet irradiation and is changed into a form that can store electrons. The charging layer 3 includes a plurality of fine particles of the n-type metal oxide semiconductor covered with the insulating coating.

The first electrode layer 6 is, for example, a negative electrode layer, and includes a first electrode 1 and an n-type metal oxide semiconductor layer 2. The n-type metal oxide semiconductor layer 2 is disposed between the first electrode 1 and the charging layer 3. Accordingly, one surface of the n-type metal oxide semiconductor layer 2 is in contact with the first electrode 1 and the other surface of the n-type metal oxide semiconductor layer 2 is in contact with the charging layer 3.

The second electrode layer 7 is, for example, a positive electrode layer, and includes a second electrode 5 and a p-type metal oxide semiconductor layer 4. The p-type metal oxide semiconductor layer 4 is disposed between the second electrode 5 and the charging layer 3. Accordingly, one surface of the p-type metal oxide semiconductor layer 4 is in contact with the charging layer 3 and the other surface of the p-type metal oxide semiconductor layer 4 is in contact with the second electrode 5. The p-type metal oxide semiconductor layer 4 is formed to prevent electrons from being injected into the charging layer 3 from the second electrode 5.

Each of the first electrode 1 and the second electrode 5 may be formed of a conductive material. Examples of a metal electrode include a silver (Ag) alloy film containing aluminum (Al). A titanium dioxide (TiO₂), a tin oxide (SnO₂), or a zinc oxide (ZnO) is used as a material of the n-type metal oxide semiconductor layer 2.

When the insulating material does not completely cover the n-type metal oxide semiconductor layer in the charging layer 3, the n-type metal oxide semiconductor may be in contact with the first electrode layer 6. In this case, the electrons may be directly injected into the n-type metal oxide semiconductor by a recoupling. The n-type metal oxide semiconductor layer 2 is formed to prevent electrons from being injected into the charging layer 3 from the first electrode layer 6. As illustrated in Fig. 1, the n-type metal oxide semiconductor layer 2 is disposed between the first electrode 1 and the charging layer 3. The n-type metal oxide semiconductor layer 2 may be omitted. The p-type metal oxide semiconductor layer 4 is formed to prevent electrons from being injected into the charging layer 3 from the upper second electrode 5. A nickel oxide (NiO), a copper aluminum oxide (CuAlO₂), and the like can be used as a material of the p-type metal oxide semiconductor layer 4.

Although the first electrode layer 6 having a double-layered structure in which the first electrode 1 and the n-type metal oxide semiconductor layer 2 are formed has been described above, the structure of the first electrode layer 6 is not limited to the double-layered structure. For example, the first electrode layer 6 may have a single layer structure in which only the first electrode 1 is formed. Similarly, the structure of the second electrode layer 7 is not limited to the double-layered structure in which the p-type metal oxide semiconductor layer 4 and the second electrode 5 are formed. The second electrode layer 7 may have a single layer structure in which, for example, only the second electrode 5 is formed. In other words, the first electrode layer 6 and the second electrode layer 7 may be composed only of a metal electrode.

### (B) Phenomenon of electron leakage

It has been considered that in the quantum battery as shown in Figs. 1 and 2, electrons accumulate only in the charging layer 3, which is sandwiched between the first electrode layer 6 and the second electrode layer 7, during charging. That is, it has been considered that electrons accumulate only in a region of the charging layer 3 that is immediately below the second electrode layer 7. However, as a result of experiments by the inventors of the present application, a phenomenon has been observed in which when electrons are filled in a region immediately below the second electrode layer 7, the electrons also diffuse to a region outside of the region immediately below the second electrode layer 7. That is, it has been proved that the electrons also diffuse to the region outside of the region immediately below the second electrode layer 7 and accumulate therein.

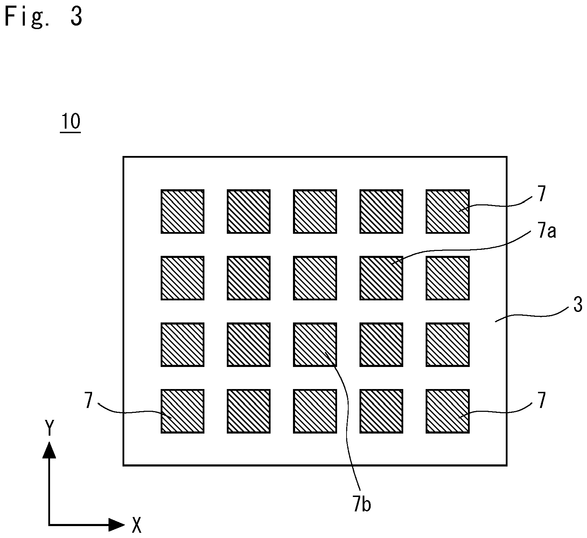

The phenomenon of electron leakage found by the inventors of the present invention will be described below. In order to find the phenomenon of electron leakage, a quantum battery 10 as shown in Fig. 3 was used. Fig. 3 is an XY plane view schematically showing a pattern shape of the second electrode layer 7 on the charging layer 3.

Referring to Fig. 3, the second electrode layers 7 of rectangular patterns are arranged in an array. Specifically, a plurality of second electrode layers 7 are arranged along an X-direction and a Y-direction. A region in which the second electrode layer 7 is not formed is disposed between the adjacent rectangular patterns of second electrode layer 7. Assume that the first electrode layer 6 (not shown in Fig. 3) is formed over substantially the entire surface of the charging layer 3.

The pattern of the second electrode layer 7 to which a charge voltage is applied is herein referred to as pattern 7a. In other words, the charge voltage is not applied to patterns other than the pattern 7a. Voltages of the respective patterns during charging of the pattern 7a and during natural discharge were measured.

As the pattern 7a is charged, pattern 7b in the vicinity of the pattern 7a is charged with a voltage. Specifically, a voltage is also generated in the pattern 7b, to which the charge voltage is not applied, based on the electrons accumulating in the charging layer 3. After the charging of the pattern 7a is stopped, the voltage of the pattern 7a decreases due to natural discharge, while the voltage of the pattern 7b increases. As a result of this experiment, it has been found that the electrons diffuse from the charged region to the region in the vicinity of the charged region.

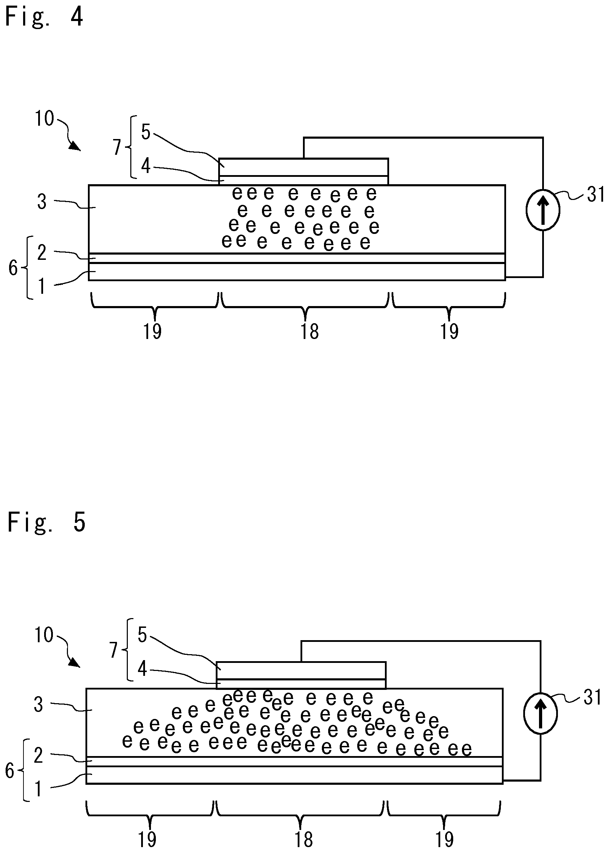

Figs. 4 to 7 are model diagrams for explaining the phenomenon of electron leakage in the quantum battery 10. Referring to Figs. 4 to 7, the first electrode layer 6 is formed over the entire surface of the charging layer 3, and the second electrode layer 7 is formed on a part of the charging layer 3. In this case, a region in which the first electrode layer 6 and the second electrode layer 7 overlap each other through the charging layer 3 is referred to as an overlapping region 18, and a region in which the first electrode layer 6 and the second electrode layer 7 do not overlap each other is referred to as a non-overlapping region 19.

First, as shown in Fig. 4, in order to charge the quantum battery 10, a power supply 31 is connected to each of the first electrode layer 6 and the second electrode layer 7, to thereby generate a charge voltage. The charge voltage generated between the first electrode layer 6 and the second electrode layer 7 is applied to the charging layer 3. During charging of the quantum battery 10, electrons (represented by "e" in the figures) start to accumulate in a region immediately below the second electrode layer 7. Specifically, electrons gradually accumulate in the overlapping region 18. When the overlapping region 18 is sufficiently filled with electrons, the electrons start to enter a region outside of the region immediately below the second electrode layer 7 as shown in Fig. 5. That is, the electrons diffuse from the overlapping region 18 to the non-overlapping region 19.

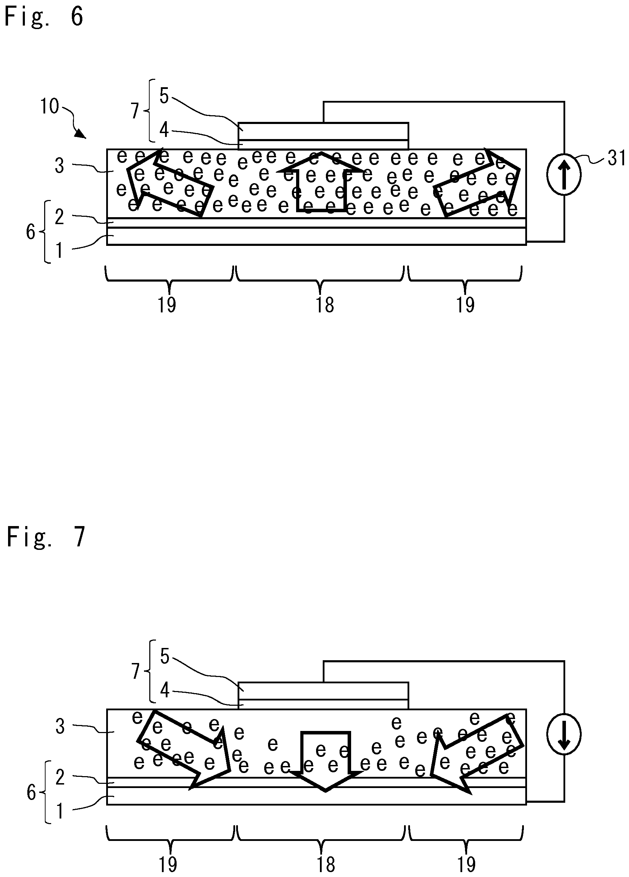

After that, as shown in Fig. 6, the electrons diffuse into the charging layer 3 until the potential becomes constant. In other words, the density of electrons in the charging layer 3 becomes uniform. Thus, the density of electrons in the overlapping region 18 is substantially the same as the density of electrons in the non-overlapping region 19. During discharging, as shown in Fig. 7, first, the electrons in the region immediately below the second electrode layer 7 are gradually discharged, and then the electrons in the region outside of the region immediately below the second electrode layer 7 are gradually discharged. That is, after the discharging is started, the density of electrons in the overlapping region 18 becomes lower than the density of electrons in the non-overlapping region 19.

Since it has been considered that electrons accumulate only in the region immediately below the second electrode layer 7, the parallel plate type structure in which the first electrode layer 6 and the second electrode layer 7 are formed over substantially the entire surface of the charging layer 3 is used as the structure of the quantum battery. However, the use of the phenomenon of electron leakage makes it possible to locally form the electrode layers. This is because the same power capacity can be obtained as long as the volume of the charging layer 3 is not changed after the electrode layers are locally formed. In other words, when the battery is fully charged, the density of electrons in the non-overlapping region 19 is substantially the same as the density of electrons in the overlapping region 18. Accordingly, the basic performance of the battery can be maintained even if the first electrode layer 6 and the second electrode layer 7 are formed without using the parallel plate type structure. Thus, the degree of freedom of layout of the first electrode layer 6 and the second electrode layer 7 is increased, which makes it possible to add a new function.

### (C) Layout of electrode layers

As described above, the phenomenon has been observed in which during charging, electrons diffuse from the overlapping region of the electrode to the non-overlapping region of the electrode. The use of such a leakage phenomenon increases the degree of freedom in the shape and layout of the electrode layers and enables a design of the battery with a new function.

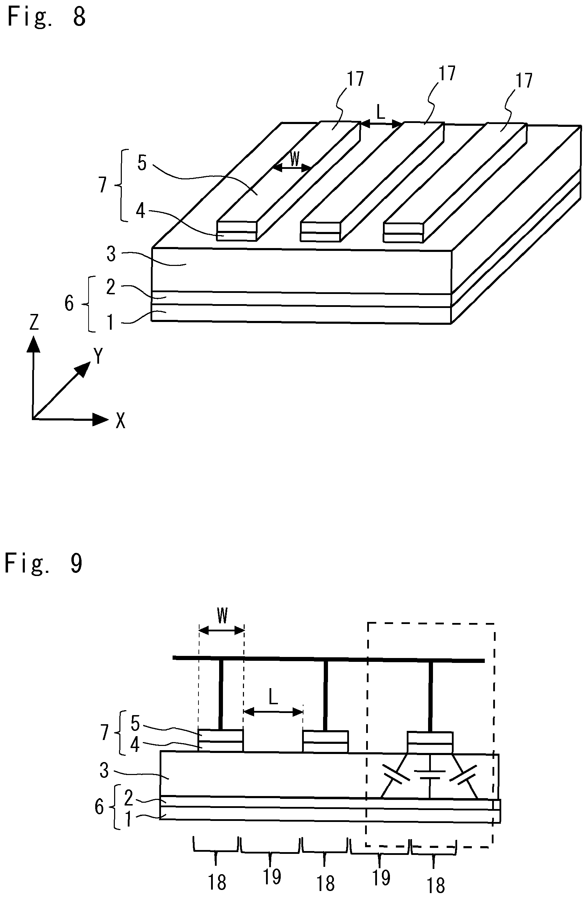

For example, in the overlapping region 18 in which the first electrode layer 6 and the second electrode layer 7 overlap each other through the charging layer 3, a response speed is high, whereas in the non-overlapping region 19 in which the first electrode layer 6 and the second electrode layer 7 do not overlap each other, the response speed is low. Accordingly, discharge characteristics can be adjusted by adjusting the areas of the overlapping region 18 and the non-overlapping region 19. This will be described with reference to Figs. 8 to 11.

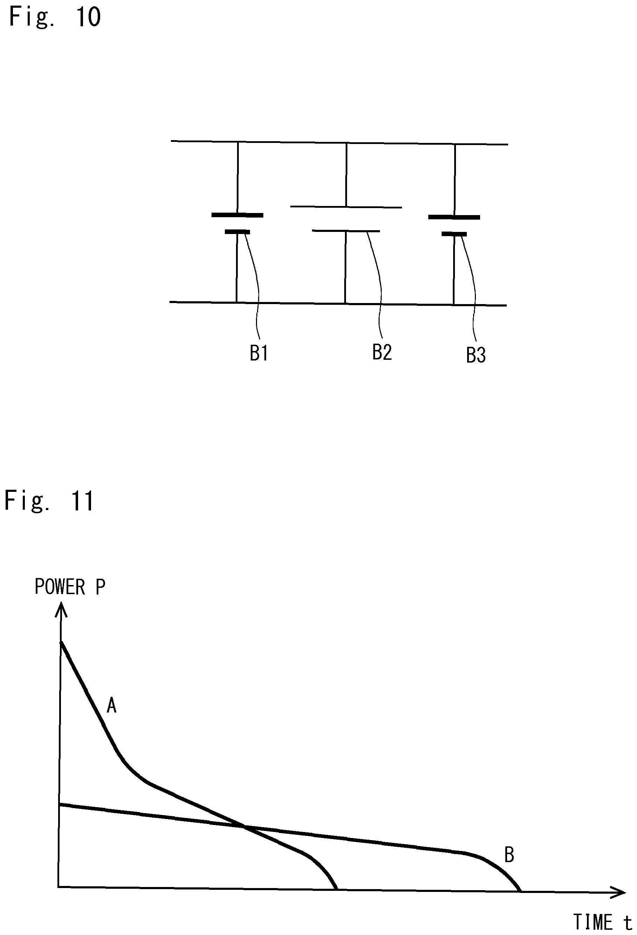

Fig. 8 is a perspective view schematically showing the structure of the quantum battery 10. Fig. 9 is a sectional view of the quantum battery 10 shown in Fig. 8. Fig. 10 is a diagram schematically showing a portion indicated by a dotted line in Fig. 9. Fig. 11 is a graph schematically showing discharge characteristics with respect to a pattern width W and a distance L between patterns of the second electrode layer 7. In Fig. 11, the horizontal axis represents time and the vertical axis represents output power.

The quantum battery 10 in which the second electrode layers 7 are each formed in a strip shape as shown in Figs. 8 and 9 will now be considered. Referring to Figs. 8 and 9, patterns 17 of the second electrode layers 7 where the Y-direction is the longitudinal direction are each formed in a rectangular shape. A plurality of patterns 17 are arranged side by side in the X-direction. The width of one pattern 17 in the X-direction is represented by W, and the distance between the adjacent patterns 17 is represented by L. The first electrode layer 6 is formed over the entire lower surface of the charging layer 3. Since an aspect ratio in the X-direction and Z-direction is extremely large, the Z-direction is ignored in the following description.

Referring to Fig. 8, on the surface (i.e., XY plane) of the charging layer 3, a region in which the second electrode layer 7 is not formed is sandwiched between regions in which the second electrode layer is formed. Further, in the X-direction, the region in which the second electrode layer 7 is not formed and the region in which the second electrode layer 7 is formed are alternately arranged. In other words, on the surface of the charging layer 3, at least a part of the region in which the second electrode layer 7 is formed is disposed between the regions in which the second electrode layer 7 is not formed, and on the surface of the charging layer 3, at least a part of the region in which the second electrode layer 7 is not formed is disposed between the regions in which the second electrode layer 7 is formed.

As described above, due to the leakage phenomenon, electrons accumulate also in the non-overlapping regions 19. Accordingly, as shown in the schematic diagram of Fig. 9, each non-overlapping region 19 functions as a battery. As described above with reference to Figs. 4 to 7, the electrons in the non-overlapping regions 19 are discharged after the electrons in the overlapping regions 18 of the patterns 17 are discharged. Thus, the response speed is high in the overlapping regions 18, and the response speed is low in the non-overlapping regions 19. As shown in Fig. 10, a battery B2 having a low response speed is present in the overlapping region 18, and batteries B1 and B3 each having a low response speed are present in the non-overlapping regions 19. In other words, the quantum battery 10 in which the battery B2 having a high response speed and the batteries B1 and B3 having a low response speed are located together can be achieved. The response speed can be changed by adjusting the pattern width W and the distance L between the patters.

For example, when the pattern width W is large and the distance L between the patterns is small, the area of each overlapping region 18 is large and the area of each non-overlapping region 19 is small. In this case, the discharge characteristics as indicated by A in Fig. 11 are obtained, and thus large power can be obtained at once. These characteristics are suitable for, for example, driving a motor that requires start-up power.

On the other hand, when the pattern width W is small and the distance L between the patterns is large, the area of each overlapping region 18 is small and the area of each non-overlapping region 19 is large. In this case, the discharge characteristics as indicated by B in Fig. 11 are obtained. The output power is small and the quantum battery 10 is gradually discharged at a slow rate. If the area of the charging layer 3 is not changed, the power capacity does not change regardless of the pattern width W and the distance L between the patterns. That is, a value obtained by integrating power P with respect to a time t in the case of A in Fig. 11 is the same as that in the case of B in Fig. 11. Accordingly, in the case of B in Fig. 11, the power to be extracted at once is limited, so that the battery can be discharged at a constant power for a long time even when a high load is applied. These characteristics are suitable for an application that is used for a long time.

As described above, the charge and discharge characteristics can be adjusted by adjusting the shape, size, and layout of the electrode layers. As the area of the overlapping region 18 is increased, the response speed can be increased. The layout of the electrode layers is changed to a local electrode structure in which the electrode layers are locally formed on the charging layer 3, thereby making it possible to optimize the charge and discharge characteristics.

When the local electrode structure is employed, a battery having a high response speed and a battery having a low response speed are located together. Thus, the structure can deal with a power source that greatly varies as in the case of natural energy power generation. For example, in the case of charging the battery with renewable energy obtained by, for example, photovoltaic power generation, wind power generation, or tidal power generation, variations in charge input are large. The quantum battery according to this embodiment can be efficiently charged with a small loss in comparison to a lithium ion battery or the like having a low response speed.

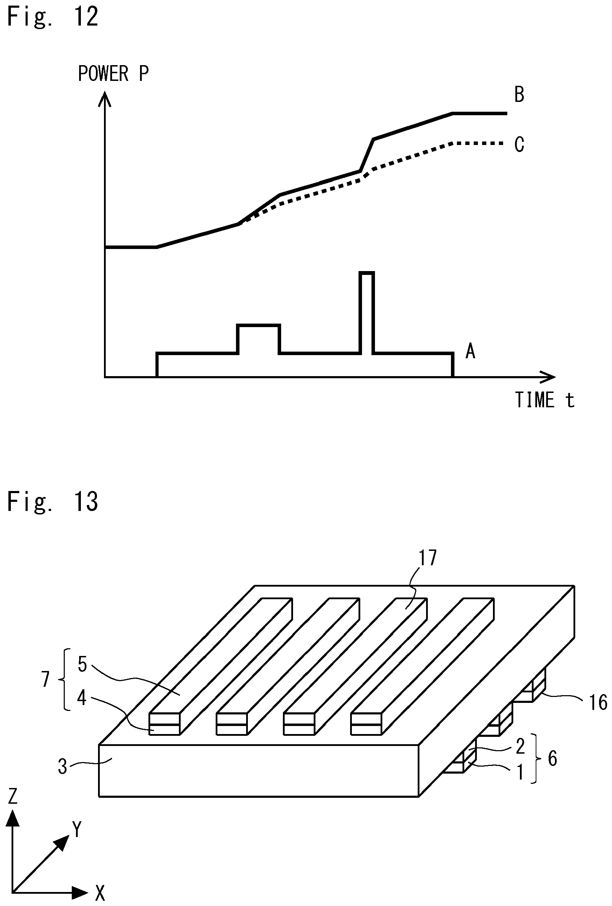

Fig. 12 shows charge characteristics when a variable power source is used. In Fig. 12, the horizontal axis represents time and the vertical axis represents power. In Fig. 12, A represents a charge input; B represents charging power of the quantum battery 10 according to this embodiment; and C represents charging power of a lithium ion battery as a comparative example.

As shown in Fig. 12, when the charge input A varies, the response speed of the quantum battery 10 with respect to the charge input is lower than that of the lithium ion battery. Specifically, since the quantum battery having a structure in which the electrode layers are locally formed includes a battery having a high response speed, the charging power B varies in accordance with a variation in the charge input. Accordingly, when the charge input A varies, the charging power B of the quantum battery 10 is higher than the charging power C of the lithium ion battery.

In this manner, the quantum battery 10 according to this embodiment can maintain the charge characteristics. Further, the quantum batteries 10 are formed in a sheet shape and stacked, thereby achieving an improvement in volume efficiency and cost reduction.

### (D) Layout of electrode layers

### (D-1) First layout example

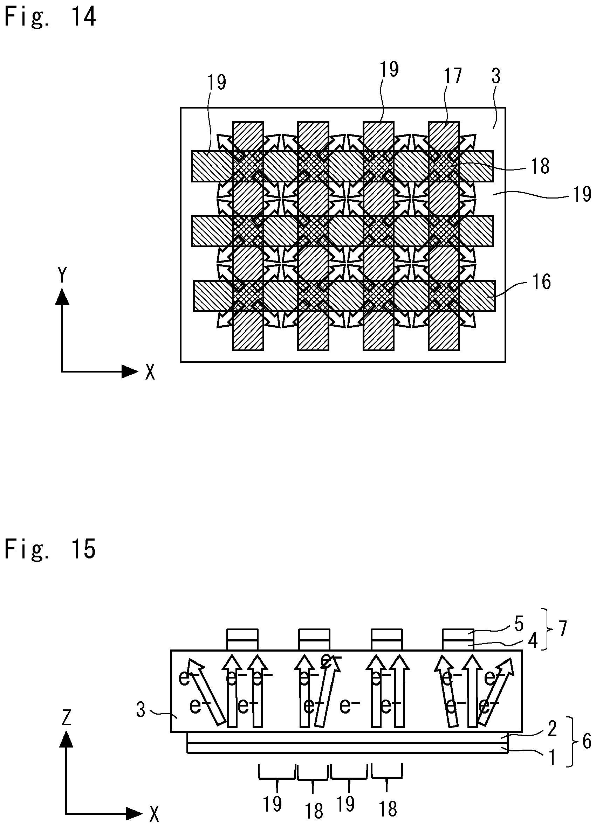

Next, a first layout example of the electrode layers will be described with reference to Figs. 13 to 15. Fig. 13 is a perspective view showing the structure of the quantum battery 10 according to the first layout example. Fig. 14 is a plan view schematically showing the layout of patterns of the quantum battery 10. Fig. 15 is a sectional view schematically showing the layout of the patterns. In the first layout example, patterns 16 of the first electrode layers 6 and patterns 17 of the second electrode layers 7 are arranged so as to intersect with each other. That is, the patterns 16 and the patterns 17 are formed in a cross-mesh structure.

Specifically, the patterns 16 of the first electrode layers 6 are rectangular patterns where the X-direction is the longitudinal direction. A plurality of patterns 16 are arranged side by side in the Y-direction. On the other hand, the patterns 17 of the second electrode layers 7 are rectangular patterns where the Y-direction is the longitudinal direction. A plurality of patterns 17 are arranged side by side in the X-direction. The patterns 17 are formed on the upper surface of the charging layer 3, and the patterns 16 are formed on the lower surface of the charging layer 3. On the surface of the charging layer 3, the second electrode layers 7 are arranged on both sides of the region in which the second electrode layer 7 is not formed.

In other words, on the surface of the charging layer 3, the region in which the second electrode layer 7 is formed is sandwiched between the regions in which the second electrode layer 7 is not formed. Further, in the X-direction, the region in which the second electrode layer 7 is not formed and the region in which the second electrode layer 7 is formed are alternately arranged. In other words, on the surface of the charging layer 3, at least a part of the region in which the second electrode layer 7 is formed is disposed between the regions in which the second electrode layer 7 is not formed, and on the surface of the charging layer 3, at least a part of the region in which the second electrode layer 7 is not formed is disposed between the regions in which the second electrode layer 7 is formed.

On the surface of the charging layer 3, the region in which the first electrode layer 6 is formed is sandwiched between the regions in which the first electrode layer 6 is not formed. In the Y-direction, the region in which the first electrode layer 6 is not formed and the region in which the first electrode layer 6 is formed are alternately arranged. In other words, on the surface of the charging layer 3, at least a part of the region in which the first electrode layer 6 is formed is disposed between the regions in which the first electrode layer 6 is not formed, and on the surface of the charging layer 3, at least a part of the region in which the first electrode layer 6 is not formed is disposed between the regions in which the first electrode layer 6 is formed.

In the XY plane view, a region where the pattern 16 and the pattern 17 intersect with each other corresponds to the overlapping region 18. A region on the outside of the overlapping region 18 corresponds to the non-overlapping region 19. The overlapping region 18 is surrounded by the non-overlapping region 19. The non-overlapping region 19 includes the region in which only the pattern 17 is formed; the region in which only the pattern 16 is formed; and the region in which neither the pattern 16 nor the pattern 17 is formed.

A region between the adjacent overlapping regions 18 corresponds to the non-overlapping region 19. More specifically, a region located at a position shifted from the overlapping region 18 in the X-direction is the non-overlapping region 19 in which the pattern 16 is present and the pattern 17 is not present. A region located at a position shifted from the overlapping region 18 in the Y-direction is the non-overlapping region 19 in which the pattern 16 is not present and the pattern 17 is present. Thus, in the XY plane view, the overlapping region 18 in which the pattern 16 and the pattern 17 overlap each other and the non-overlapping region 19 in which the pattern 16 and the pattern 17 do not overlap each other are alternately arranged.

During charging, electrons start to accumulate in the overlapping region 18, and then the electrons are dispersed into the non-overlapping regions 19 as indicated by arrows in Fig. 14. In the first layout example, the electrode layers are formed in a cross-mesh structure, and thus the dispersions of electrons from the overlapping regions 18 is uniform. In other words, the electrons are uniformly dispersed from the overlapping region 18. Also during discharging, the electrons are uniformly discharged in the same manner.

### (D-2) Second layout example not forming part of the invention

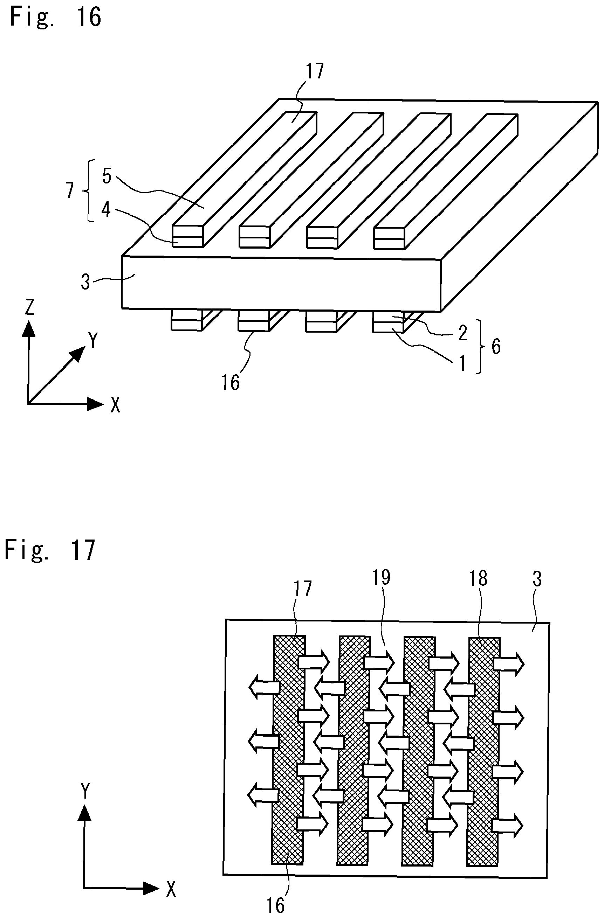

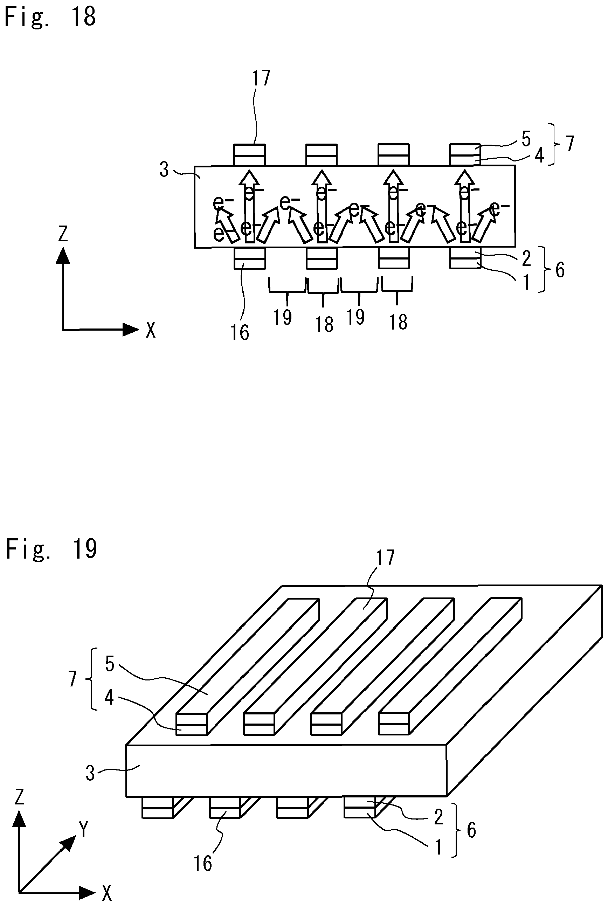

A second layout example of the electrode layers will be described with reference to Figs. 16 to 18. Fig. 16 is a perspective view showing the structure of the quantum battery 10 according to the second layout example. Fig. 17 is a plan view schematically showing the layout of patterns of the second layout example. Fig. 18 is a sectional view schematically showing the second layout example of the quantum battery 10. In the second layout example, the patterns 16 of the first electrode layers 6 and the patterns 17 of the second electrode layers 7 are arranged so as to overlap each other.

In the second layout example, the patterns 16 of the first electrode layers 6 and the patterns 17 of the second electrode layers 7 are provided in parallel and arranged so as to overlap each other. Specifically, a corresponding one of the patterns 16 and a corresponding one of the patterns 17 have a face-to-face structure in which they face each other at the same position in the XY plane view. On the surface of the charging layer 3, the second electrode layers 7 are arranged on both sides of the region in which the second electrode layer 7 is not formed. In the X-direction, the overlapping regions 18 and the non-overlapping regions 19 are alternately arranged.

On the surface of the charging layer 3, the region in which the second electrode layer 7 is formed is sandwiched between the regions in which the second electrode layer 7 is not formed. In the X-direction, the region in which the second electrode layer 7 is not formed and the region in which the second electrode layer 7 is formed are alternately arranged. In other words, on the surface of the charging layer 3, at least a part of the region in which the second electrode layer 7 is formed is disposed between the regions in which the second electrode layer 7 is not formed, and on the surface of the charging layer 3, at least a part of the region in which the second electrode layer 7 is not formed is disposed between the regions in which the second electrode layer 7 is formed.

On the surface of the charging layer 3, the region in which the first electrode layer 6 is formed is sandwiched between the regions in which the first electrode layer 6 is not formed. In the X-direction, the region in which the first electrode layer 6 is not formed and the region in which the first electrode layer 6 is formed are alternately arranged. In other words, on the surface of the charging layer 3, at least a part of the region in which the first electrode layer 6 is formed is disposed between the regions in which the first electrode layer 6 is not formed, and on the surface of the charging layer 3, at least a part of the region in which the first electrode layer 6 is not formed is disposed between the regions in which the first electrode layer 6 is formed.

In the second layout example, the patterns 16 and the patterns 17 are rectangular patterns where the Y-direction is the longitudinal direction. Each of the patterns 16 and each of the patterns 17 have the same size. A corresponding one of the patterns 16 and a corresponding one of the patterns 17 are arranged at the same position in the XY plane. Accordingly, each of the patterns 16 is located immediately below the corresponding pattern 17. In other words, the entire area of each pattern 16 matches the area of the overlapping region 18. Accordingly, assuming that the pattern areas of the patterns 16 and 17 in the first layout example are the same as those in the second layout example, the area of the overlapping region 18 in the second layout example is larger than that in the first layout example.

Since the area of the overlapping region 18 is large, the rate of accumulation of electrons in the region between the electrode layers is high. On the other hand, since the pattern 16 or the pattern 17 is not present in the non-overlapping region 19, the rate of dispersion of electrons is low. Specifically, the rate of diffusion of electrons from the overlapping region 18 to the non-overlapping region 19 is low.

### (D-3) Third layout example not forming part of the invention

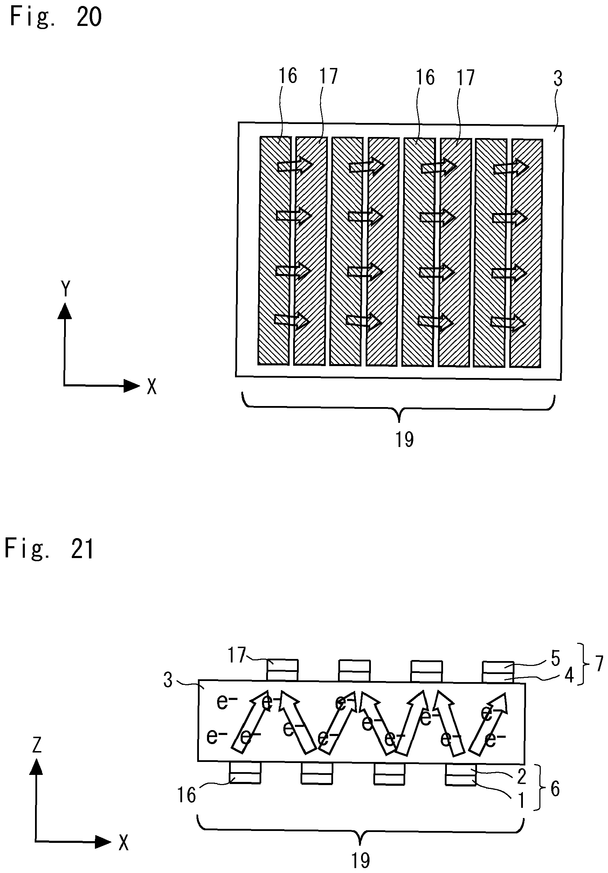

A third layout example of the electrode layers will be described with reference to Figs. 19 to 21. Fig. 19 is a perspective view showing the structure of the quantum battery 10 according to the third layout example. Fig. 20 is a plan view schematically showing the third layout example of the quantum battery 10. Fig. 21 is a sectional view schematically showing the third layout example of the quantum battery 10.

In the third layout example, the patterns 16 of the first electrode layers 6 and the patterns 17 of the second electrode layers 7 are provided in parallel and arranged so as not to overlap each other. That is, in the XY plane view, the patterns 16 and the patterns 17 have a staggered structure in which they are alternately arranged. On the surface of the charging layer 3, the second electrode layers 7 are disposed on both sides of the region in which the second electrode layer 7 is not formed.

In other words, on the surface of the charging layer 3, the region in which the second electrode layer 7 is formed is sandwiched between the regions in which the second electrode layer 7 is not formed. Further, in the X-direction, the region in which the second electrode layer 7 is not formed and the region in which the second electrode layer 7 is formed are alternately arranged. In other words, on the surface of the charging layer 3, at least a part of the region in which the second electrode layer 7 is formed is disposed between the regions in which the second electrode layer 7 is not formed, and on the surface of the charging layer 3, at least a part of the region in which the second electrode layer 7 is not formed is disposed between the regions in which the second electrode layer 7 is formed.

Not according to the invention, on the surface of the charging layer 3, the region in which the first electrode layer 6 is formed is sandwiched between the regions in which the first electrode layer 6 is not formed. In the X-direction, the region in which the first electrode layer 6 is not formed and the region in which the first electrode layer 6 is formed are alternately arranged. In other words, on the surface of the charging layer 3, at least a part of the region in which the first electrode layer 6 is formed is disposed between the regions in which the first electrode layer 6 is not formed, and on the surface of the charging layer 3, at least a part of the region in which the first electrode layer 6 is formed is disposed between the regions in which the first electrode layer 6 is formed.

In the third layout example not forming part of the invention, the patterns 16 and the patterns 17 are rectangular patterns where the Y-direction is the longitudinal direction. Each of the patterns 16 and each of the patterns 17 have the same size. In the XY plane, the patterns 16 and the patterns 17 are alternately arranged. Each of the patterns 17 is disposed between two adjacent patterns 16 in the XY plane view. In other words, the patterns 16 and the patterns 17 are alternately arranged in the X-direction.

Accordingly, the patterns 16 are not located immediately below the respective patterns 17. In other words, the entire area of each pattern 16 does not overlap the area of each pattern 17. The overlapping region 18 is not present in the third layout example.

The overlapping region 18 is not present and only the non-overlapping region 19 is present. Accordingly, in the third layout example, electrons gradually accumulate during charging, and the electrons are gradually discharged during discharging.

In this manner, the degree of freedom of the shape, size, and layout of the patterns 16 and 17 of the electrode layers is increased, thereby making it possible to obtain desired charge and discharge characteristics. More specifically, the area ratio between the overlapping region 18 and the non-overlapping region 19 can be set to a desired value by adjusting the shape, size, layout, or the like of the patterns 16 and 17. Thus, the layout of the patterns is designed so that appropriate charge and discharge characteristics can be obtained. The layout of the patterns 16 and 17 is not limited to the first to third layout examples as a matter of course.

Note that the structures of the first to third layout examples can be combined. For example, the patterns 16 and 17 each having a strip shape may be formed in parallel and only a part of each pattern 16 may overlap the corresponding pattern 17. Specifically, the pattern 17 may be formed by shifting it by a half pitch of the corresponding pattern 16. Alternatively, the pattern 16 where the X-direction is the longitudinal direction and the pattern 17 where the Y-direction is the longitudinal direction may be formed on the charging layer 3.

In the first to third layout examples, the region in which the electrode layer is not formed and the region in which the electrode layer is formed are alternately arranged in the X-direction or the Y-direction. However, the direction in which the regions are alternately arranged is not particularly limited. That is, it is only necessary that the region in which the electrode layer is formed and the region in which the electrode layer is not formed be alternately arranged in an arbitrary direction on the surface of the charging layer 3.

Not according to the invention, as long as one of the first electrode layer 6 and the second electrode layer 7 is locally formed on the charging layer 3, the other one of the first electrode layer 6 and the second electrode layer 7 may be formed over substantially the entire surface of the charging layer 3.

Furthermore, the patterns 16 and 17 to be used during charging are different from the patterns 16 and 17 to be used during discharging. During charging, a charge voltage is applied to the entire area of the patterns 16 and 17. This allows rapid charging. On the other hand, during discharging, only some of the plurality of patterns 16 are connected to a load or the like. As a result, the power to be extracted at once is limited and the battery can be discharged for a long time.

Thus, in this embodiment, at least one of the first electrode layer 6 and the second electrode layer 7 includes a plurality of electrode layer patterns formed separately from each other. During charging, a charge voltage is supplied to each of the plurality of electrode patterns, and during discharging, a load is connected to some of the plurality of electrode patterns. The use of such a charging and discharging method makes it possible to appropriately control charging and discharging.

In this manner, the electrode layer is formed by dividing it into a plurality of patterns, so that the area of the overlapping region 18 during charging can be made different from the area of the overlapping region 18 during discharging. For example, the area of the overlapping region 18 during discharging can be set to be smaller than the area of the overlapping region 18 during charging. Alternatively, the area of the overlapping region 18 during discharging can be set to be larger than the area of the overlapping region 18 during charging. The first electrode layer 6 and the second electrode layer 7 is divided into a plurality of patterns, thereby making it possible to obtain desired charge and discharge characteristics.

In the first to third layout examples, the first electrode layer 6 is divided into the plurality of patterns 16 and the second electrode layer 7 is divided into the plurality of patterns 17. However not according to the invention, one of the electrode layers may have an integrated pattern. For example, the first electrode layer 6 or the second electrode layer 7 may be formed over substantially the entire area of the charging layer 3. Alternatively, the first electrode layer 6 or the electrode layer 7 may be formed with an integrated pattern of a predetermined shape so that the first electrode layer 6 or the electrode layer 7 is formed locally on the charging layer 3. It is only necessary that at least one of the first electrode layer 6 and the second electrode layer 7 be divided into a plurality of patterns. With this structure, the area of the overlapping region 18 during charging can be made different from the area of the overlapping region 18 during discharging. In other words, the area ratio between the overlapping region 18 and the non-overlapping region 19 during charging can be set to be different from the area ratio between the overlapping region 18 and the non-overlapping region 19 during discharging. Thus, the charge and discharge characteristics can be optimized.

### (E) Application to a regeneration system

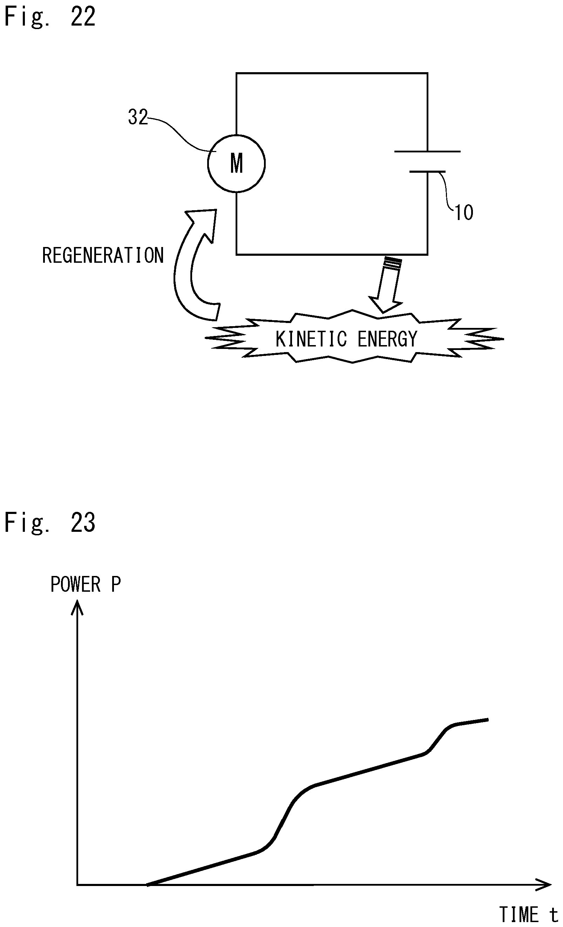

As described above, the quantum battery 10 has charge characteristics which can deal with charging by a variable power source. Further, the quantum battery 10 has discharge characteristics capable of obtaining large start-up power at once. The quantum battery 10 having a combination of the charge and discharge characteristics is applicable to a regeneration system as shown in Fig. 22.

In the regeneration system shown in Fig. 22, a motor 32 serving as a power source and the quantum battery 10 serving as a power source of the motor 32 are connected to each other. The motor 32 operates with power supplied from the quantum battery 10. The quantum battery 10 is charged with kinetic energy (regenerative energy) generated when the motor 32 is decelerated.

Fig. 23 shows charging power in the regeneration system. As shown in Fig. 23, the charging power is not constant, but varies in the regeneration system. For example, regenerative energy is generated only when the motor 32 is decelerated. Also in such a case, charging can be efficiently performed by using the quantum battery 10.

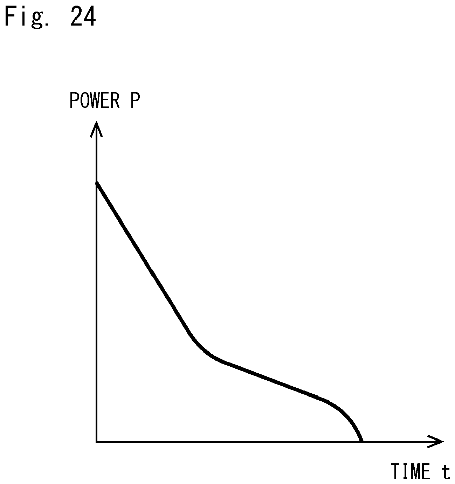

Fig. 24 shows discharging power at start-up of the motor 32 in the regeneration system. At start-up of the motor 32, large start-up power is required. Also in such a case, the quantum battery 10 can discharge large power at once. This enables rapid start-up of the motor 32.

While embodiments of the present invention have been described above, the present invention includes appropriate modifications as long as the object and advantageous effects of the present invention are not impaired. Further, the present invention is not limited by the above embodiments and is defined by the appended claims.

This application is based upon and claims the benefit of priority from Japanese patent application No. 2015-133351, filed on July 2, 2015.

### Reference Signs List

- 1: FIRST ELECTRODE
- 2: N-TYPE METAL OXIDE SEMICONDUCTOR LAYER
- 3: CHARGING LAYER
- 4: P-TYPE METAL OXIDE SEMICONDUCTOR LAYER
- 5: SECOND ELECTRODE
- 6: FIRST ELECTRODE LAYER

- 7: SECOND ELECTRODE LAYER
- 10: QUANTUM BATTERY
- 16: PATTERN
- 17: PATTERN
- 18: OVERLAPPING REGION
- 19: NON-OVERLAPPING REGION
- 31: POWER SUPPLY
- 32: MOTOR

## Claims

1. A battery (10) comprising:
a first electrode layer (6);
a second electrode layer (7);
a charging layer (3), disposed between the first electrode layer (6) and the second electrode layer (7), and the charging layer (3) including an n-type metal oxide semiconductor and an insulating material,
a charging circuit, and
a connection circuit,
wherein the insulating material is formed as a coating on n-type metal oxide fine particles,
wherein the first electrode layer (6) includes a plurality of electrode layer patterns (16) formed separately from each other,
wherein the second electrode layer (7) includes a plurality of electrode layer patterns (17) formed separately from each other, **characterised in that**
in a planar view through the charging layer, a longitudinal direction of the plurality of electrode patterns (16) of the first electrode layer (6) is a first direction, and a longitudinal direction of the plurality of electrode patterns (17) of the second electrode layer (7) is a second direction intersecting the first direction,
the charging circuit being configured to generate a charging voltage between the first electrode layer and the second electrode layer and configured to apply the charging voltage to the charging layer, the charging circuit being configured to supply, during charging, the charging voltage to each of the plurality of electrode patterns (16, 17), and
the connection circuit is configured to connect, during discharging, some of the plurality of electrode patterns (16, 17) to a load.

2. The battery (10) according to Claim 1 , wherein in a planar view through the charging layer, an overlapping region in which the pattern (16) of the first electrode layer and the pattern of the second electrode layer (17) overlap each other and a non-overlapping region in which the pattern of the first electrode layer and the
pattern of the second electrode layer do not
overlap each other are alternately formed.

3. A system including a battery (10) according to claim 1 or 2 and a natural energy power generator, wherein the charging circuit charges the charging layer with power generated by the natural energy power generator.

4. A system including a battery (10) according to claim 1or 2 and a motor, wherein the charging circuit charges the charging layer with regenerated energy from the motor, and wherein power charged in the charging layer is used for a power source of the motor.

5. A method of charging and discharging a battery (10), wherein :
- the battery comprises:
- a first electrode layer (6); a second electrode layer (7); and a charging layer (3) including an n-type metal oxide semiconductor and an insulating material, wherein the insulating material is formed as a coating on n-type metal oxide fine particles, a charging circuit, and wherein the charging circuit being configured to supply, during charging, a charging voltage, the charge voltage generated between the first electrode layer (6) and the second electrode layer (7) is applied to the charging layer, the first electrode layer (6) including a plurality of patterns (16) formed separately from each other, the second electrode layer (7) including a plurality of patterns (17) formed separately from each other, **characterised in that** the method
comprising:
charging the charging layer by supplying the charge voltage to each of the plurality of patterns (16, 17); and
discharging the charging layer by connecting a load to some of the plurality of patterns (16, 17), wherein in a planer view through the charging layer, a longitudinal direction of the plurality of electrode patterns (16) of the first electrode layer (6) is a first direction, and a longitudinal direction of the plurality of electrode patterns (17) of the second layer (7) is a second direction intersecting the first direction.

6. The method according to Claim 5, wherein in a planar view through the charging layer (3), an overlapping region in which the pattern of the first electrode layer (6) and the pattern of the second electrode layer (7) overlap each other and a non-overlapping region in which the pattern of the first electrode layer and the pattern of the second electrode layer do not overlap each other are alternately formed.

7. The method according to claim 5 or 6 wherein the charging circuit charges the charging layer (3) with power generated by a natural energy power generator.

8. The method according to claim 5 or 6 and wherein the charging circuit charges the charging layer (3) with regenerated energy from a motor, and wherein power charged in the charging layer (3) is used for a power source of the motor.

## Patentansprüche

1. Batterie (10), umfassend:
eine erste Elektrodenschicht (6);
eine zweite Elektrodenschicht (7);
eine Ladeschicht (3) zwischen der ersten Elektrodenschicht (6) und der zweiten Elektrodenschicht (7), und wobei die Ladeschicht (3) einen n-Typ-Metalloxidhalbleiter und ein Isoliermaterial aufweist;
einen Ladeschaltkreis; und
einen Verbindungsschaltkreis;
wobei das Isoliermaterial als ein Überzug auf n-Typ-Metalloxidfeinpartikeln ausgebildet ist;
wobei die erste Elektrodenschicht (6) eine Mehrzahl von
Elektrodenschichtmustern (16) aufweist, die getrennt voneinander ausgebildet sind;
wobei die zweite Elektrodenschicht (7) eine Mehrzahl von
Elektrodenschichtmustern (17) aufweist, die getrennt voneinander ausgebildet sind; **dadurch gekennzeichnet, dass**
in einer planaren Ansicht durch die Ladeschicht eine Längsrichtung der Mehrzahl von Elektrodenmustern (16) der ersten Elektrodenschicht (6) eine erste Richtung ist und eine Längsrichtung der Mehrzahl von Elektrodenmustern (17) der zweiten Elektrodenschicht (7) eine zweite Richtung ist, welche die erste Richtung kreuzt;
wobei der Ladeschaltkreis so gestaltet ist, dass er eine Ladespannung zwischen der ersten Elektrodenschicht und der zweiten Elektrodenschicht erzeugt, und wobei der Ladeschaltkreis so gestaltet ist, dass er die Ladespannung an die Ladeschicht anlegt, wobei der Ladeschaltkreis so gestaltet ist, dass er während dem Laden die Ladespannung an jedes der Mehrzahl von Elektrodenmuster (16, 17) anlegt, und
wobei der Verbindungsschaltkreis so gestaltet ist, dass er einige der Mehrzahl von Elektrodenmuster (16, 17) während dem Entladen mit einem Verbraucher verbindet.

2. Batterie (10) nach Anspruch 1, wobei in einer planaren Ansicht durch die Ladeschicht ein Überlappungsbereich, in dem sich das Muster (16) der ersten Elektrodenschicht und das Muster der zweiten Elektrodenschicht (17) gegenseitig überlappen, und ein überlappungsfreier Bereich, in dem sich das Muster der ersten Elektrodenschicht und das Muster der zweiten Elektrodenschicht nicht gegenseitig überlappen, wechselweise ausgebildet sind.

3. System, das eine Batterie (10) nach Anspruch 1 oder 2 aufweist und einen natürliche Energieleistungsgenerator, wobei der Ladeschaltkreis die Ladeschicht mit durch den natürliche Energieleistungsgenerator erzeugter Energie lädt.

4. System, das eine Batterie (10) nach Anspruch 1 oder 2 aufweist und einen Motor, wobei der Ladeschaltkreis die Ladeschicht mit regenerierter Energie von dem Motor lädt, und wobei die in der Ladeschicht geladene Energie für eine Energiequelle des Motors verwendet wird.

5. Verfahren zum Laden und Entladen einer Batterie (10), wobei:
- die Batterie folgendes umfasst:
- eine erste Elektrodenschicht (6); eine zweite Elektrodenschicht (7); und eine Ladeschicht (3), die einen n-Typ-Metalloxidhalbleiter und ein Isoliermaterial aufweist, wobei das Isoliermaterial als ein Überzug auf n-Typ-Metalloxidfeinpartikeln ausgebildet ist, einen Ladeschaltkreis, und wobei der Ladeschaltkreis so gestaltet ist, dass er während dem Laden eine Ladespannung zuführt, wobei die Ladespannung, die zwischen der ersten Elektrodenschicht (6) und der zweiten Elektrodenschicht (7) erzeugt wird, der Ladeschicht zugeführt wird, wobei die erste Elektrodenschicht (6) eine Mehrzahl von Mustern (16) aufweist, die getrennt voneinander ausgebildet sind, wobei die zweite Elektrodenschicht (7) eine Mehrzahl von Mustern (17) aufweist, die getrennt voneinander ausgebildet sind; **dadurch gekennzeichnet, dass** das Verfahren folgendes umfasst:
Laden der Ladeschicht durch Zufuhr der Ladespannung an jedes der Mehrzahl von Mustern (16, 17); und
Entladen der Ladeschicht durch Verbindung eines Verbrauchers mit einigen der Mehrzahl von Mustern (16, 17), wobei in einer planaren Ansicht durch die Ladeschicht eine Längsrichtung der Mehrzahl Elektrodenmustern (16) der ersten Elektrodenschicht (6) eine erste Richtung ist und eine Längsrichtung der Mehrzahl von Elektrodenmustern (17) der zweiten Elektrodenschicht (7) eine zweite Richtung ist, welche die erste Richtung kreuzt.

6. Verfahren nach Anspruch 5, wobei in einer planaren Ansicht durch die Ladeschicht (3) ein Überlappungsbereich, in dem sich das Muster der ersten Elektrodenschicht (6) und das Muster der zweiten Elektrodenschicht (7) gegenseitig überlappen, und ein überlappungsfreier Bereich, in dem sich das Muster der ersten Elektrodenschicht und das Muster der zweiten Elektrodenschicht nicht gegenseitig überlappen, wechselweise ausgebildet sind.

7. Verfahren nach Anspruch 5 oder 6, wobei der Ladeschaltkreis die Ladeschicht (3) mit durch einen natürliche Energieleistungsgenerator erzeugter Energie lädt.

8. Verfahren nach Anspruch 5 oder 6, und wobei der Ladeschaltkreis die Ladeschicht (3) mit regenerierter Energie von einem Motor lädt, und wobei die in der Ladeschicht (3) geladene Energie für eine Energiequelle des Motors verwendet wird.

## Revendications

1. Batterie (10) comprenant :
une première couche d'électrode (6) ;
une seconde couche d'électrode (7) ;
une couche de charge (3), disposée entre la première couche d'électrode (6) et la seconde couche d'électrode (7), et la couche de charge (3) comprenant un semi-conducteur d'oxyde métallique de type n et un matériau isolant,
un circuit de charge, et
un circuit de connexion,
le matériau isolant étant formé d'un revêtement sur des particules fines d'oxyde métallique de type n,
la première couche d'électrode (6) comprenant une pluralité de motifs de couche d'électrode (16) formés séparément les uns des autres,
la seconde couche d'électrode (7) comprenant une pluralité de motifs de couche d'électrode (17) formés séparément les uns des autres, **caractérisée en ce que**
dans une vue plane à travers la couche de charge, une direction longitudinale de la pluralité de motifs d'électrode (16) de la première couche d'électrode (6) est une première direction, et une direction longitudinale de la pluralité de motifs d'électrode (17) de la seconde couche d'électrode (7) est une seconde direction coupant la première direction,
le circuit de charge étant conçu pour générer une tension de charge entre la première couche d'électrode et la seconde couche d'électrode et conçu pour appliquer la tension de charge à la couche de charge, le circuit de charge étant conçu pour fournir, pendant la charge, la tension de charge à chacun des différents motifs d'électrode (16, 17), et
le circuit de connexion étant conçu pour connecter, pendant la décharge, une partie de la pluralité de motifs d'électrodes (16, 17) à une charge.

2. Batterie (10) selon la revendication 1, dans une vue plane à travers la couche de charge, une région de chevauchement dans laquelle le motif (16) de la première couche d'électrode et le motif de la seconde couche d'électrode (17) se chevauchent l'un l'autre et une région de non-chevauchement dans laquelle le motif de la première couche d'électrode et le motif de la seconde couche d'électrode ne se chevauchent pas étant formées en alternance.

3. Système comprenant une batterie (10) selon la revendication 1 ou 2 et un générateur d'énergie naturelle, le circuit de charge chargeant la couche de charge avec l'énergie générée par le générateur d'énergie naturelle.

4. Système comprenant une batterie (10) selon la revendication 1 ou 2 et un moteur, le circuit de charge chargeant la couche de charge avec l'énergie régénérée du moteur, et l'énergie chargée dans la couche de charge étant utilisée pour une source d'énergie du moteur.

5. Procédé de charge et de décharge d'une batterie (10),
- la batterie comprenant :
- une première couche d'électrode (6) ; une seconde couche d'électrode (7) ; et une couche de charge (3) comprenant un semi-conducteur d'oxyde métallique de type n et un matériau isolant, le matériau isolant étant formé comme un revêtement sur des particules fines d'oxyde métallique de type n, un circuit de charge, et le circuit de charge étant conçu pour fournir, pendant la charge, une tension de charge, la tension de charge générée entre la première couche d'électrode (6) et la seconde couche d'électrode (7) étant appliquée à la couche de charge, la première couche d'électrode (6) comprenant une pluralité de motifs (16) formés séparément les uns des autres, la seconde couche d'électrode (7) comprenant une pluralité de motifs (17) formés séparément les uns des autres, **caractérisé en ce que** le procédé comprend les étapes consistant à :
charger la couche de charge en fournissant la tension de charge à chacun de la pluralité de motifs (16, 17) ; et
décharger la couche de charge en connectant une charge à certains de la pluralité de motifs (16, 17), dans une vue en plan à travers la couche de charge, une direction longitudinale de la pluralité de motifs d'électrode (16) de la première couche d'électrode (6) étant une première direction, et une direction longitudinale de la pluralité de motifs d'électrode (17) de la seconde couche (7) étant une seconde direction coupant la première direction.

6. Procédé selon la revendication 5, dans une vue en plan à travers la couche de charge (3), une zone de chevauchement dans laquelle le motif de la première couche d'électrode (6) et le motif de la seconde couche d'électrode (7) se chevauchent et une zone sans chevauchement dans laquelle le motif de la première couche d'électrode et le motif de la seconde couche d'électrode ne se chevauchent pas étant formées en alternance.

7. Procédé selon la revendication 5 ou 6, le circuit de charge chargeant la couche de charge (3) avec l'énergie générée par un générateur d'énergie naturelle.

8. Procédé selon la revendication 5 ou 6 et le circuit de charge chargeant la couche de charge (3) avec l'énergie régénérée d'un moteur, et l'énergie chargée dans la couche de charge (3) étant utilisée pour une source d'énergie du moteur.
